# EUROPEAN PATENT SPECIFICATION

(11) **EP 1 791 345 B1**
(45) Date of publication and mention of the grant of the patent: **11.01.2012**
(21) Application number: 06124687.2
(22) Date of filing: 23.11.2006
(51) Int. Cl.: H04N 5/355, H01L 27/146

(54) **Image sensor pixel with multiple outputs**
Bildsensorpixel mit mehreren Ausgängen
Pixel de capteur d'image à plusieurs sorties

(30) Priority: 24.11.2005 EP 05111264
(43) Date of publication of application: 30.05.2007
(73) Proprietor: STMICROELECTRONICS SA, 92120 Montrouge (FR)
(72) Inventor: Lule, Tarek, 38120 Saint Egrève (FR)
(74) Representative: de Beaumont, Michel

(56) References cited:
- WO-A-2006/073875
- JP-A- 2003 134 396

## Description

### FIELD OF THE INVENTION

The present invention relates to solid-state image sensors, specifically to charge detection elements of image sensors detecting any kind of radiation such as but not limited to visible light.

### BACKGROUND OF THE INVENTION

A typical image sensor senses radiation by converting impinging radiation into charges that are integrated (collected) in sensor pixels. During or after completion of an integration cycle, the charge is converted into a voltage that is supplied to the output terminals of the sensor.

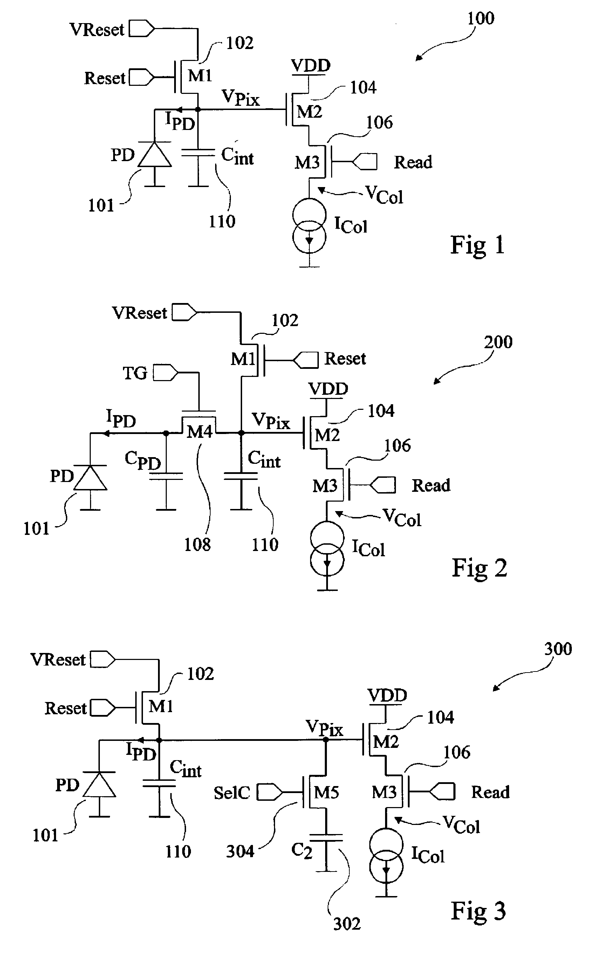

Typical basic pixel architectures are built around 3 or 4 transistors, the so called 3T and 4T architectures which are shown in Figures 1 and 2 labelled 100 and 200 respectively. With reference to Figures 1 and 2, in these architectures a photodiode PD 101 converts received radiation into a charge, and a first transistor M1, labelled 102, is dedicated to resetting the sensing node, while two further transistors, M2 and M3, labelled 104, 106, are dedicated to the selective readout of a signal voltage generated inside the pixel. A fourth transistor M4, labelled 108 and shown in the 4T configuration of Figure 2, is provided to transfer signal charges from the radiation sensing element to a separate charge storage node.

Commonly, an integration capacitor C_{Int} of the sensor, which stores a charge related to the impinging radiation, is provided by the parasitic capacitances of the source of transistor 102 and the gate of transistor 104 and the wiring between these components, all of which are usually tried to be kept small, so as to increase the sensitivity of the image sensor. This capacitance is represented by capacitor 110 in Figures 1 and 2.

Both architectures are limited in their dynamic range by the charge handling capacity, also called pixel Full Well (FW), which is defined as the amount of charge that can be stored by the integration capacitor C_{Int} 110 without exceeding the voltage range that can be handled by the reset transistor M1 102, the transfer transistor M4 108 in the case of architecture 200 of Figure 2, the readout transistors M2 104 and M3 106, and the subsequent stages of signal processing. Since a larger dynamic range allows for better image quality, one of the targets of image sensor design is to increase the charge handling capacity of the pixel.

One approach for increasing the charge handling capacity is to increase the capacitance of the integration capacitor, C_{Int} 110, through the addition of an extra capacitor in parallel. An example of this solution, called 4TC, is described by H. Rhodes in "CMOS imager technology shrinks and image performance", published on pages 7-18 in "2004 IEEE Workshop on Microelectronics and Electron Devices".

While in this solution this extra capacitive charge handling capability is permanently effective, an alternative approach is described in the "2003 Workshop on CCDs and Advanced Image Sensors" in a paper titled "Programmable sensitivity image sensor with multi-capacitance CMOS pixels" from Ryutaro Oi of Universtiy of Tokyo, and such an image sensor 300 is shown in Figure 3. Here, the additional capacitor C2, labelled 302, is connected to a radiation sensing node V_{Pix} through a select transistor M5 304 controlled by a select signal SelC. Node V_{Pix} is a node at which the charge generated by photodiode 101 is stored. Principally the pixel can be operated in two modes: one high full well mode with transistor M5 304 turned ON and thus capacitor C2 added in parallel to capacitor Cᵢₙₜ to give a larger full well; the other with transistor M5 304 turned OFF to give a higher sensitivity while compromising the capacity of the full well. But, according to the authors, this pixel also allows operation with high full well and high sensitivity in one and the same integration frame, by turning ON and OFF the select transistor M5 304 during integration. However, during readout, the charge stored by the capacitor Cᵢₙₜ must be read out first, then transistor M5 304 is turned ON again to allow the charges stored by capacitor C₂ to be read out.

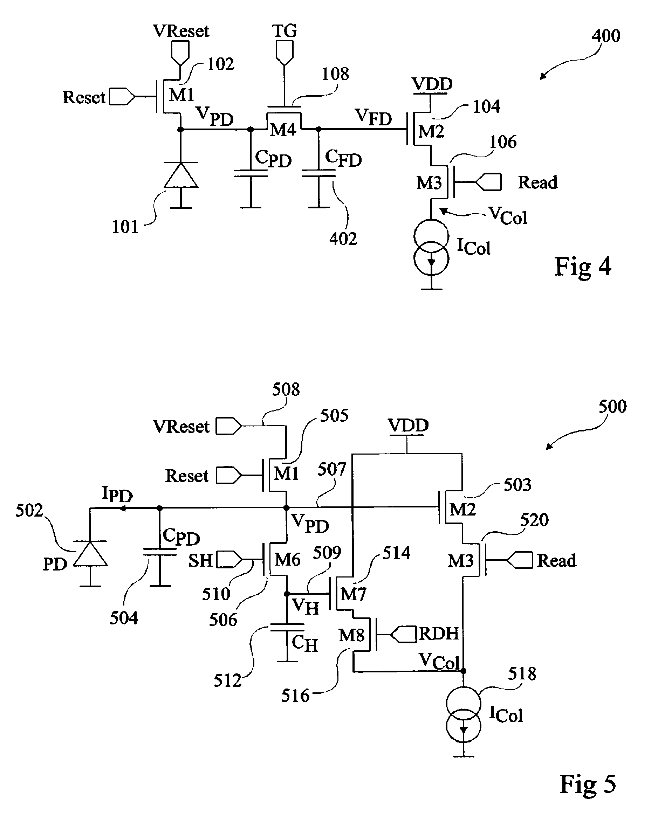

It can be a further requirement in various applications to provide a global shutter to reduce motion distortion, especially where the time to read the sensor plane is long compared to typical motion distortion times, such as in the case of multi-megapixel sensors. A solution that has been proposed is depicted in Figure 4, which shows a image sensor 400 similar to the circuit of Figure 2, except that reset transistor M1 102 is connected directly to photodiode 101 in image sensor 400 and the integration capacitor C_{Int} 110 of Figure 2 has been replaced by a charge handling capacitor C_{FD} 402. An example of such a circuit is for example disclosed in paper titled "A high speed camera system based on an image sensor in standard CMOS technology", Hillebrand, M et al. As shown in Figure 4, the transfer gate transistor M4 304 is used here to separate the charge storage capacitor C_{FD} from the radiation-sensing diode at the end of the integration period. While the signal stored by capacitor C_{FD} can be held until the pixel is read out, the next integration period can be launched by applying a reset pulse to the gate of M1 thus resetting the radiation-sensing diode voltage to the reset voltage ready to be discharged by the subsequent integration phase.

Thus this solution allows the operation of a global shutter mode, but does not allow operation with variable sensitivity, as provided by the solution in Figure 3. On the other hand, the selectable sensitivity solution in Figure 3 does not allow the operation of a global shutter mode. In certain demanding applications both modes are required together in one device.

Japanese publication JP 2003 134396 discloses a picture element in Figure 2 having capacitors C1 and C2 coupled to a first source follower amplifier and a capacitor C3 coupled to a second source follower amplifier.

### SUMMARY OF THE INVENTION

It is an object of the present invention to at least partially overcome limitations in the prior art. It is a further object of embodiments of the present invention to provide a pixel architecture that allows selecting multiple different operating modes that each pixel can operate in.

According to a first aspect of the present invention there is provided an image sensor as defined in claims 1 to 5

According to a further aspect of the present invention there is provided method of sensing an image using an image sensor as defined in claims 6 to 13.

### BRIEF DESCRIPTION OF THE DRAWINGS

The foregoing and other purposes, features, aspects and advantages of the invention will become apparent from the following detailed description of embodiments, given by way of illustration and not limitation with reference to the accompanying drawings, in which:
Figure 1 is a circuit diagram of a three transistor (3T) image sensing pixel;
Figure 2 is a circuit diagram of a four transistor (4T) image sensing pixel;
Figure 3 is a circuit diagram of a three transistor (3T) pixel with additional fourth transistor that allows selectable operation in high or low sensitivity modes;
Figure 4 is a circuit diagram of a pixel with four transistors allowing operation in a global shutter mode;
Figure 5 is a simplified circuit diagram of an image sensing pixel according to a first embodiment of the present invention;
Figure 6 is a timing diagram relating to an embodiment of the present invention;
Figure 7 is a graph showing signal voltage as a function of illumination relating to the embodiment of Figure 5;
Figure 8 is a timing diagram relating to the embodiment of Figure 5;
Figure 9 is a simplified circuit diagram of an image sensing circuit according to another embodiment of the present invention;
Figure 10 is a timing diagram relating to the embodiment of Figure 9;
Figure 11 is a graph showing signal voltage as a function of illumination relating to the embodiment of Figure 9; and
Figure 12 is a schematic view of an image sensor according to embodiments of the present invention.

The figures form a part of the overall description of the invention. Throughout the figures like reference numerals are used for like components.

### DETAILED DESCRIPTION OF THE INVENTION

Figure 5 represents a simplified circuit diagram of an image sensing pixel 500 according to one embodiment.

The sensing pixel of Figure 5 comprises a photodiode PD 502 connected between a reference ground potential and a node 507 connected to the gate node of a MOS transistor M2 503, and having a parasitic capacitance represented by capacitor C_{PD} 504 and shown connected in parallel to it. The voltage across the photodiode and capacitor C_{PD} 504 is labelled V_{PD}. The gate node of transistor M2 503 is further connected to a first signal node of a MOS transistor M1 505, and to a first signal node of a MOS transistor M6 506. Transistor 505 receives a reset signal at its gate node, and has its second signal node connected to an input signal V_{Reset} on line 508. Transistor M6 506 has its gate node connected to an input signal S_{H} on line 510, and its second signal node connected to the reference ground potential via a capacitor C_{H} 512. The second signal node of transistor M6 506 is also connected at node 509 to the gate node of a transistor M7 514, the voltage at node 509 being labelled V_{H}. The first signal node of transistor M7 514 is connected to reference potential V_{DD}, whilst the second signal node of transistor M7 514 is connected to a first signal node of a further MOS transistor M8 516, which receives a signal RDH at its gate node, and has its second signal node connected to the ground reference potential via a current source I_{Col}. 518. The voltage across the current source I_{Col} 518 is labelled V_{Col}. A further MOS transistor M3 520 is also connected between the second signal node of transistor M8 516 and a first signal node of transistor M2 503, via its first and second signal nodes, and receives a read signal at its gate node. The second signal node of transistor M2 503 is connected to reference potential V_{DD}.

In operation, transistor 505 M1 provides the function of resetting the voltage across the radiation-sensing diode 502 and its associated parasitic capacitance C_{PD} 504. For this purpose the reset voltage V_{Reset} applied to the second signal node, for example the drain node, of transistor M1 505 is transferred to the first signal node, for example the source, node of transistor M1 505 when the Reset voltage is applied to the gate node of transistor M1 503 to turn it ON.

Transistors M2 503 and M3 520 provide a possible embodiment of readout transistors, configured to operate in a source follower operation: Transistor M2 503 represents the driver of the source follower supplied through its drain by V_{DD}. Current source I_{Col} 518, usually common to all pixels in the column, represents the load of the source follower. Transistor M3 520 is used to select only one specific pixel at a time in a column through the activation signal Read.

Transistor M6 506 and capacitor C_{H} 512 perform the function of allowing the full well capacitance of the device to be increased. While the gate signal of transistor M6 506, called S_{H}, is activated, the capacitance C_{H} 512 is connected in parallel to capacitor C_{PD} 504. This increases the charge handling capability of the pixel due to the increased effective capacitance. At the same time a signal can be stored by capacitor C_{H} 512 at any time by turning OFF transistor M6 506.

Transistors M7 514 and M8 516 are readout transistors associated specifically with the capacitor C_{H} 512. This means that the pixel has two independent readout paths. In this preferred embodiment, the two readout paths are connected to the same column line V_{Col} and turned ON separately through two separate enable signals READ and RDH, but other configurations for multiple readout paths are also possible.

This additional capacitor and readout path allows, among other possible operation modes, the following main operating modes:

### a) High sensitivity operation:

Transistor M6 506 stays off in this mode, so the pixel has a higher sensitivity.

### b) High full well operation:

Transistor M6 506 stays on in this mode, so the pixel has a higher charge handling capability giving better image quality. Both readout paths can be turned ON at the same time thereby increasing readout speed and reducing pixel fixed pattern noise and flicker noise.

### c) High Dynamic Range operation:

Firstly, in a reset phase, signals S_{H} and Reset are turned ON to reset the voltages across capacitors C_{PD} 504 and C_{H} 512. When the signal Reset is turned OFF, the integration phase with high full well begins, wherein the two capacitors C_{PD} 504 and C_{H} 512 are connected in parallel and the radiation-generated current from the radiation-sensing photodiode PD 502 discharges the two capacitors simultaneously. Then the signal S_{H} is turned OFF so that the connection between capacitor C_{PD} 504 and capacitor C_{H} 512 is interrupted and the integration phase with high sensitivity begins. The voltage at V_{H} is kept frozen from the end of the high full well integration phase since the photocurrent does not discharge capacitor C_{H} 512 anymore and at the same time the photocurrent discharges capacitor C_{PD} 504 alone which results in a higher sensitivity to signal charges. This integration phase is terminated by the consecutive readout of the two voltages of capacitors C_{PD} 504 and C_{H} 512 by turning ON signals READ and RDH separately in the final read phase. From here, a new integration cycle can restart.

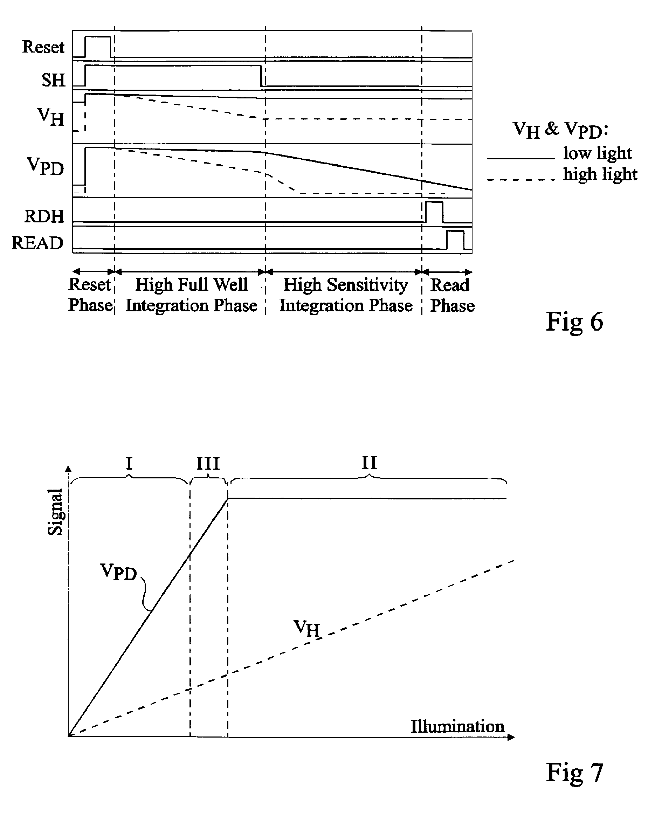

The exemplary timing diagram shown in Figure 6, with arbitrarily selected relationships between the duration of the different pulses and phases, shows the evolution of each of the voltages V_{H} and V_{PD} for two exemplary cases of high illumination (dashed lines) and low illumination (solid lines). At high illumination, voltage V_{H} reaches a useful signal at the end of the high full well integration phase, while photodiode PD 502 becomes saturated in the following high sensitivity integration phase. So the useful information can be readout from capacitor C_{H} 512 at node 509. If, on the other hand, the illumination is low, then the signal collected during the high full well phase and stored by voltage V_{H} across capacitor C_{H} 512 at the end of this phase is very small and would not give a good quality image signal. However, in the subsequent high-sensitivity integration phase, the photocurrent suffices to produce a sufficient signal stored as V_{PD}, which is then read out at the end of the integration phase at node 507.

For lower illuminations, the high sensitivity signal, read out as the voltage V_{PD} across the photodiode capacitance C_{PD} using transistors M2 503 and M3 520 by turning ON the signal READ, gives a useful image content value until it saturates for a certain medium illumination level. Above that the high full well signal, read out as voltage V_{H} across capacitance C_{H} 512 using transistors, M7 514 and M8 516 by turning ON signal RDH, continues to give a useful image content for higher illuminations until that also saturates when the total charge storage capacity of the sensor is reached.

The total signal range can thus be subdivided into three different regions as shown in Figure 7, separated by dash-dotted lines: region I where the signal is gained from V_{PD}, region II where the signal is gained from V_{H}, and an intermediate region III where the signal can be gained from a mix of both signals.

### d) Global Shutter Operation:

The signals for global shutter operation are provided in a similar fashion to signals provided for the High Dynamic Range Operation. An important difference is in the relationship between the pixels in different rows. In the high dynamic range operation the pixels are reset, integrated and read out in a row-by-row fashion. This is commonly referred to as a rolling shutter operation wherein the integration phases take place at periods shifted in time between the different rows of one image.

The global shutter operation is implemented in the present embodiment as follows:

Firstly all pixels of the sensor are reset at the same time in the global reset phase by applying the signal Resent, while the signal S_{H} is also turned ON in all pixels to ensure that node 509 is reset as well as node 507. Next, the integration phase starts in all pixels simultaneously by turning OFF Reset. Thus all pixels capture the incoming radiation at the same time. This global integration phase is terminated by turning OFF all the S_{H} signal lines for all pixels simultaneously, thus freezing the signal content on capacitor C_{H} of all pixels, ready to be read out.

The readout in the global readout phase still takes place in a row by row fashion, such that every pixel waits for a different duration before being read out. A certain pixel is read out by turning ON the signal RDH only, since only the information on capacitor C_{H} is relevant in this mode of operation. Then the pixel has to wait for the rest of the pixels to be read out before the global readout phase is over and a next image capture cycle can start.

Preferably an image sensor comprises an array of the individual pixels such as the pixel shown in Figure 5, arranged in a grid to form rows and columns. In each pixel in a column the node labelled V_{Col} which connects the second signal node of transistor M3 520 to the current source 518, is connected to a common column line, each of these column lines being connected to a current source. Although the pixel of Figure 5 is illustrated including a current source, only one such current source is preferably provided per column. The current source can comprise a current mirror, for example. The read inputs RDH and Read of each pixel in a row are preferably respectively connected together to form a row read line for Read, and a second row read line for RDH. In this way, the read signals can be applied to each row in turn to output the required signals from each pixel of a row onto a different column line. Likewise, the signals V_{Reset} and Reset, as well as S_{H} of each pixel in a row can be connected such that rows of pixels can be controlled and reset at the same time. In the case of the global shutter mode, the signal S_{H} is set for all the pixels in the array at the same time. It will be apparent that alternative arrangements of the pixels are possible.

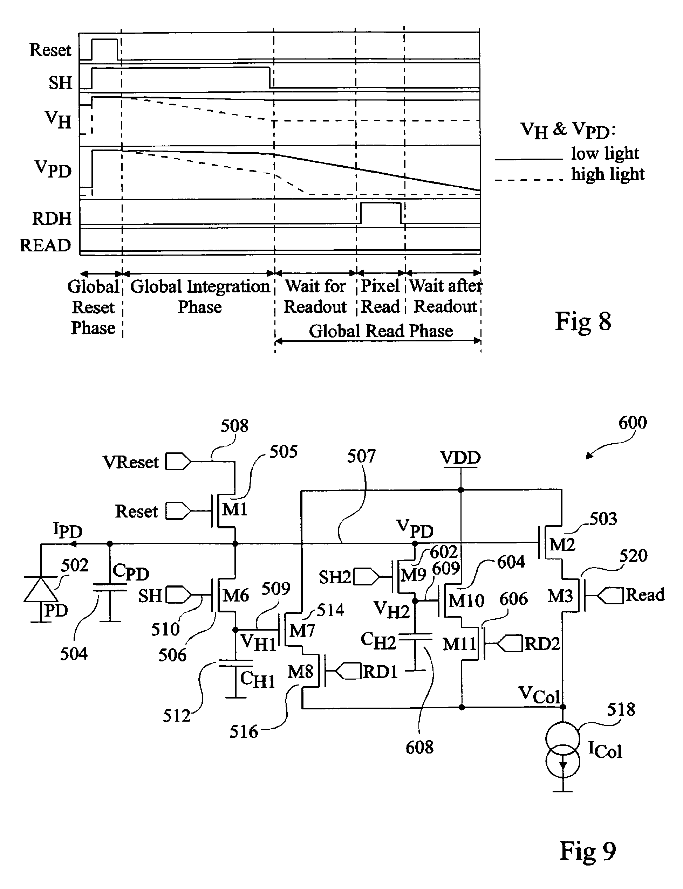

Figure 9 represents a simplified circuit diagram of an image sensing pixel 600 according to a further embodiment.

The circuitry of the image sensing pixel of Figure 9 is identical to the circuitry of Figure 5, but further comprises three MOS transistors M9, M10 and M11 , labelled 602, 604 and 606 respectively, and a capacitor C_{H2} 608 arranged in the same way as and in parallel to MOS transistors M6, M7 and M8 and capacitor C_{H} of Figure 5. In Figure 9, capacitor C_{H} of Figure 5 has been relabelled C_{H1}, the input signals S_{H} and RD have been relabelled S_{H1} and R_{D1}, and the voltage V_{H} has been relabelled V_{H1}.

As with transistor M6 506, a first signal node of transistor M9 602 is connected to the gate node of transistor M2 503, and the gate node of transistor M9 602 is connected to an input signal S_{H2}. The second signal node of transistor M9 602 is connected to the reference ground potential via a capacitor C_{H2}. The voltage across this capacitor is labelled V_{H2}. The second signal node of transistor M9 602 is also connected to the gate node of transistor M10 604. The first signal node of transistor M10 604 is connected to reference potential V_{DD}, whilst the second signal node of transistor M10 604 is connected to a first signal node of transistor M11 606, which receives an input signal RD2 at its gate node, and has its second signal node connected to the ground reference potential via the current source I_{Col} 518, described in relation to Figure 5.

In addition to the main readout path, the embodiment of Figure 9 comprises two sample/hold elements with two associated readout paths:
- Transistors M2 503 and M3 520 read the signal VPD across the photodiode capacitance when signal READ is turned ON;
- The signal V_{H1} is connected to voltage V_{PD} through transistor M6 506 while signal S_{H1} is turned ON and separated when S_{H1} is turned OFF. Transistors M7 514 and M8 516 read the signal V_{H1} across capacitor C_{H1} when RD1 is turned ON;
- The signal V_{H2} is connected to voltage V_{PD} through transistor M9 602 while signal S_{H2} is turned ON and separated when signal S_{H2} is turned OFF. Transistors M10 604 and M11 606 read the signal V_{H2} across capacitor C_{H2} when signal RD2 is turned ON.

The two additional sample/hold elements and associated readout paths allow, among other possible operation modes, the following main operating modes:

### a) High sensitivity operation:

Transistors M6 506 and M9 602 stay off in this mode, so the pixel has a higher sensitivity, the photodiode capacitance 504 providing the only storage capacitance of the pixel.

### b) High full well operation:

Transistors M6 506 and/or M9 602 stay on in this mode by turning ON signals S_{H1} and/or S_{H2}, so that the pixel has a higher charge handling capability giving better image quality. By selecting only one or both of the SH signals, the amount of full well can be selected in two different steps. If capacitors C_{H1} 512 and C_{H2} 608 have different capacitance values, then altogether four different full well modes are available. One with transistors M6 506 and M9 602 off, one with transistors M6 506 on and M9 602 off, one with transistor M6 506 off and transistor M9 602 on, and one with both transistors M6 506 and M9 602 on.

It is possible to turn ON up to three readout paths at the same time thereby increasing readout speed and reducing pixel fixed pattern noise and flicker noise.

### c) High Dynamic Range Operations:

As before, the capacitors C_{H1} 512 and/or C_{H2} 608 are connected at the beginning of the integration phase and then disconnected during the integration phase to deliver signals at different full wells and different sensitivity levels.

Since two sample/hold stages are available in the pixel, either one or the other or both sample/hold stages can be disconnected during the integration phase, allowing for different sub-modes of the high dynamic range operating mode.

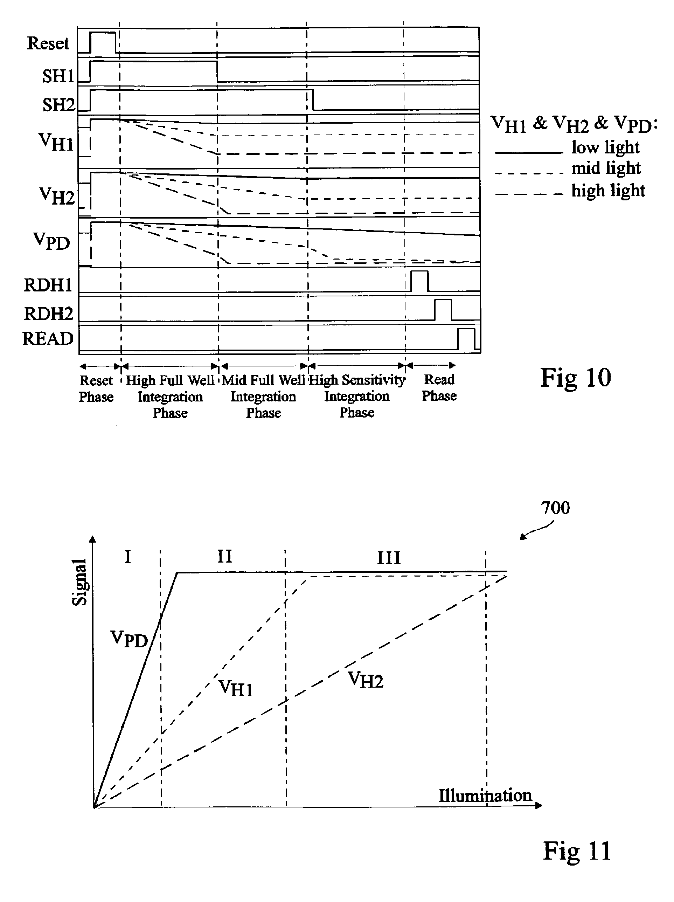

If both sample/hold stages are disconnected in the course of the integration phase, then they would preferably be disconnected at different points in time to give two distinctly different signals valid for two largely different illumination ranges. In this case three different signals are available from one pixel (see sample timing diagram Figure 10)

As shown in Figure 10, firstly there is the signal V_{H1} across capacitor C_{H1} 512 from the sample/hold stage that was turned OFF first and which has the lowest sensitivity to light since it was collected for the shortest time and has the largest total capacitance connected to V_{PD}.

Secondly there is the signal V_{H2} across capacitor C_{H2} 608 from the sample/hold stage that was turned OFF second and which has higher sensitivity to light than the first signal since it was collected for a longer time and has a smaller total capacitance connected to V_{PD}.

Thirdly there is the signal V_{PD} across the photodiode capacitance which continues integration until the end of the integration phase, and in that last phase, having the smallest total capacitance, it thus has the highest sensitivity to radiation.

With reference now to Figure 11, the total signal range can thus be subdivided into at least three different regions (see dash-dotted lines in Figure 11): region I where the signal is gained from the voltage V_{PD}, region II where the signal is gained from the voltage V_{H2}, and region III where the signal is gained from the voltage V_{H1}. In the transitions between regions I and II as well between regions II and III a mix of the two signals V_{PD} plus V_{H2}, and V_{H2} plus V_{H1}, respectively may be used. The transitions between each of these regions for example occurs a little before saturation of each signal respectively.

### d) Global Shutter Operation

The signals for global shutter operation can be provided in an identical fashion to the signals in the global shutter operation of the embodiment of Figure 5 described above.

### e) Read While Integrate Operation

According to the embodiment of Figure 9, a read while integrate operation is possible. This operation mode operates very similarly to the global shutter operation, but two sample/hold stages and associated readout stages are provided for the storage of the integrated signal at the end of the global operation cycle. In order to make best use of these two stages, they are operated in an alternating fashion.

In one frame cycle the information is integrated and stored on capacitor C_{H1} 512 by turning ON signal S_{H1} only while the information integrated and stored on capacitor C_{H2} 608 in the previous frame is readout through transistors M10 604 and M11 606 by turning ON signal RD1 on the different pixels sequentially.

At the end of the cycle, signal S_{H1} is turned OFF to freeze the information on capacitor C_{H1} 512. The next cycle begins by turning ON signals S_{H2} and Reset in all pixels to reset the previous information stored on capacitor C_{H2} 608. Then the integration of the next image information on capacitor C_{H2} 608 for all pixels simultaneously can be started by turning OFF signal Reset on all pixels. At the same time the information stored before on capacitor C_{H1} 512 in all pixels is now read out through transistors M7 514 and M8 516 by turning ON signal RD2 on the different pixels sequentially.

The readout path of transistors M2 503 and M3 520 is not necessary in this mode of operation, but could for example be used to non-destructively monitor the progress of the global integration operation while the readout operation is performed throughout the image sensor arrangement.

An image sensor for example comprises an array of the pixels of Figure 9, arranged in a grid as described above in relation the embodiment of Figure 5. The signal S_{H1} and S_{H2} can be connect together for pixels in the same row to allow rows of pixels to be controlled together. Again, alternative arrangement of the pixels is possible.

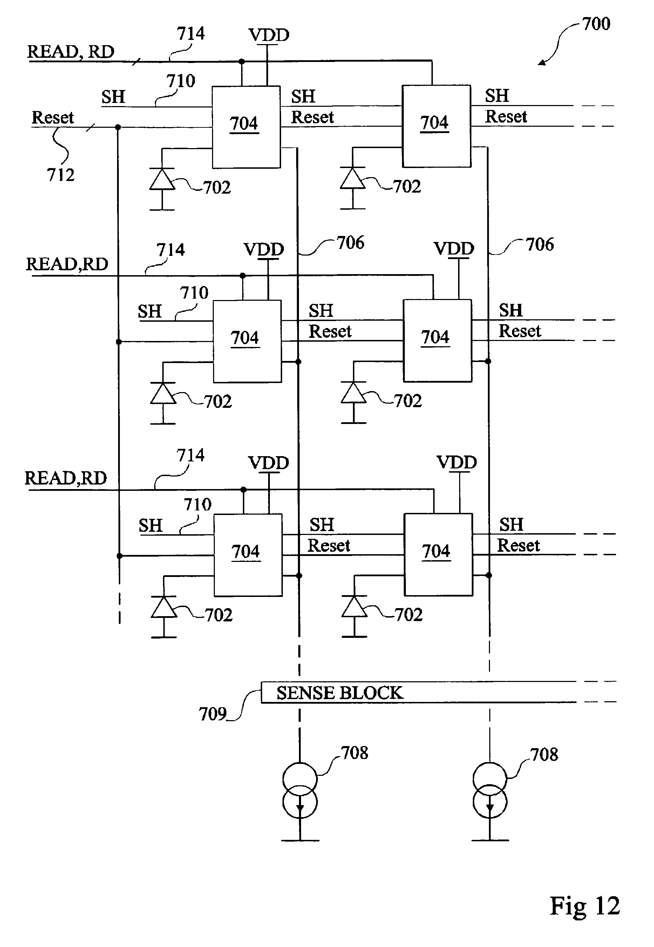

Figure 12 illustrates part of an image sensor 700 comprising an array of photodiodes 702 each operating as a radiation sensor, and a pixel circuitry 704 connected to each photodiode 702. Each photodiode 702 and pixel circuitry 704 together comprise, for example, the image sensing pixel 500 of Figure 5 or the image sensing pixel 600 of Figure 9.

The pixels are connected in grid formed of rows and columns. Column lines 706 are provided, and as explained above, the output node V_{COL} of each pixel 704 is connected to a common column line. Two such column lines 706 are illustrated in Figure 12, although generally many more columns will be provided. Each column line is also connected to a current source 708, and to a sense block 709 for receiving and processing data read from the image sensor.

Three rows of the image sensor are shown, however again there will generally be many more. The rows are connected to common control lines 710, reset lines 712, and read lines 714. In particular, a control line 710 is provided for each row of the image sensor and is connected to each pixel circuit 704 in the row. Signal SH is applied to control line 710. In the embodiment of Figure 5, this signal corresponds to the signal provided on line 510 to transistor M6 506. In the embodiment of Figure 9, this signal comprises two signals, a first signal SH1 provided on line 510 to transistor M6 506, and a second signal SH2 provided to transistor 602. As explained above, this signal can be applied to each row in turn, or to all of the pixels in the image sensor to perform a global shutter operation.

Reset line 712 is connected to all of the pixel circuits 704 of the image sensor, such that a global reset can be performed. In alternative embodiments reset can be performed row by row.

Read lines 714 are connected to each the pixel circuits 704 of each row of the image sensor 700. A first read line is connected to transistor M3 520 providing the signal READ. In the embodiment of Figure 5, a further read signal RDH is provided to transistor 516 of each pixel circuit. In the embodiment of Figure 9, two further read signals RD1 and RD2 are provided connected to transistors M8 516 and M11 606 respectively. In the present embodiment, each row is therefore read one by one, and the data collected and processed by sense block 709.

Thus embodiments of the present invention provide an image sensing element for sensing an image comprising multiple readout elements each equipped with a dedicated charge holding element which can be selectively connected to or disconnected from the radiation sensing element. In particular they can independently read the voltage at their respective dedicated charge holding element, which are provided in the form of first and second nodes each having a respective capacitance. Thus reading the voltage at the first node does not affect the voltage stored at the second node and reading the voltage at the second node does not affect the voltage stored at the first node. Furthermore, the charge handling capacity of the image sensing element is increased while allowing the readout of the integrated charge to be conducted independently of further integration operations.

Whilst the embodiments described above comprise a photodiode for sensing the radiation, in alternative embodiments of the invention alternative types of photosensors could be used. Furthermore, whilst in the embodiments described above, the transistors are n-channel or p-channel MOS transistors, in other embodiments alternative transistor types could be used, such as bipolar transistors.

Whilst in the embodiments described above, capacitance C_{PD} comprises the capacitance of the photodiode, in alternative embodiments this capacitance could be provided by other means, such as capacitance between signal paths, the parasitic capacitance at transistor gates, or by a capacitor specifically provided for that purpose. Likewise, the hold capacitors C_{H}, C_{H1} and C_{H2} are capacitances that may be provided by any means, for example by dedicated capacitors or by the inherent capacitance of these nodes.

Whilst a number of embodiments have been described comprises a number of advantageous features, in alternative embodiments of the present invention these features may be combined in any combination.

Having thus described at least one illustrative embodiment of the invention, various alterations, modifications and improvements will readily occur to those skilled in the art. Such alterations, modifications and improvements are intended to be within the scope of the invention. Accordingly, the foregoing description is by way of example only and is not intended to be limiting. The invention is limited only as defined in the following claims.

## Claims

1. An image sensor comprising a plurality of pixels each comprising:
a photosensor (502);
a first node (507) having a first capacitance and connected to said photosensor;
a second node (509) having a second capacitance and selectively connected to said photosensor;
reading means (503, 520, 516, 514) operable to read independently a first voltage value stored at said first node, and a second voltage value stored at said second node;
switching means (506) for selectively connecting said second node to said photosensor; and **characterised in that**, to sense an image, the image sensor is arranged to control said switching means to connect, during a first integration phase, said second node to said photosensor; to control said switching means to disconnect, during a second integration phase, said second node from said photosensor; and to control said reading means to independently read the first and second voltage values at the end of the second integration phase.

2. The image sensor of claim 1, wherein said reading means comprises first reading circuitry (503, 520) operable to read said first voltage value and second reading circuitry (506, 514) operable to read said second voltage value.

3. The image sensor of claim 1 or 2, further comprising a first transistor (506) controllable to selectively connect said second node to said photosensor.

4. The image sensor of any preceding claim, further comprising a third node (609) having a third capacitance and selectively connected to said photosensor, wherein said image sensor is further arranged to control said switching means to:
connect, during said first and second integration phases, said third node to said photosensor; and
disconnect, during a third integration phase, said second and third nodes from said photosensor.

5. The image sensor of any preceding claim, further comprising resetting means (505) for resetting the first and second voltage values at the first and second nodes.

6. A method of sensing an image using an image sensor comprising a plurality of pixels each comprising a photosensor (502), a first node (507) having a first capacitance connected to said photosensor, a second node (509) having a second capacitance, and switching means (506) for selectively connecting said second node to said photosensor, said method comprising a variable sensitivity mode comprising the characterising steps of:
controlling said switching means to connect, during a first integration phase, said second node to said photosensor;
storing a second voltage value at said second node;
controlling said switching means to disconnect, during a second integration phase, said second node from said photosensor;
storing a first voltage value at said first node; and
independently reading said first and second voltage values at the end of the second integration phase .

7. The method of claim 6, wherein said pixels of said image sensor are arranged in rows and said steps of said variable sensitivity mode of operation are performed on the pixels of each row sequentially.

8. The method of claim 6 or 7, further comprising a shutter mode of operation comprising the steps of, for each pixel in said image sensor, storing a third voltage value at said second node, controlling said switching means to isolate said second node from said photosensor, and reading said third voltage value.

9. The method of claim 8, wherein said shutter mode step of controlling said switching means to isolate said second node is performed at the same time in all the pixels of said image sensor.

10. The method of any of claims 6 to 9, further comprising:
a high sensitivity mode of operation comprising the steps of controlling, during said high sensitivity mode, said switching means to disconnect said second node from said photosensor, storing a fourth voltage value at said first node, and reading said fourth voltage value.

11. The method of claims 6 to 10, further comprising:
a high capacity mode of operation comprising controlling, during said high capacity mode, said switching means to connect said second node to said photosensor, storing a fifth voltage value at said first and second nodes, and reading said fifth voltage value from said first and second nodes.

12. A method of claim 6, wherein the image sensor further comprises a third node (609) having a third capacitance and selectively connected to said photosensor, said method comprising a read while integrate mode comprising alternating between first and second phases of operation, said first phase comprising reading a first voltage value stored at said second node while storing a second voltage value at said third node, said second phase comprising reading a second voltage value stored at said third node while storing a first voltage value at said second node.

13. The method of claim 12, wherein said first phase comprises, before reading said first voltage value stored at said second node, controlling a first switching means to disconnect said second node from said photosensor, and controlling a second switching means to connect said third node to said photosensor, and wherein said second phase comprises, before reading said voltage value stored at said third node, controlling said second switching means to disconnect said third node from said photosensor, and controlling said first switching means to connect said second node to said photosensor.

## Patentansprüche

1. Ein Bildsensor, der eine Vielzahl von Pixel aufweist, die ferner Folgendes aufweisen:
einen Photosensor (502);
einen ersten Knoten (507) mit einer ersten Kapazität, wobei der Knoten mit dem Photosensor verbunden ist;
einen zweiten Knoten (509) mit einer zweiten Kapazität, wobei der Knoten selektiv mit dem Photosensor verbunden ist;
Lesemittel (503, 520, 516, 514), die betrieben werden können, um unabhängig einen ersten Spannungswert, der an dem ersten Knoten gespeichert ist, zu lesen, und einen zweiten Spannungswert, der an dem zweiten Knoten gespeichert ist;
Schaltmittel (506) zum selektiven Verbinden des zweiten Knotens mit dem Photosensor; **dadurch gekennzeichnet**, um ein Bild abzutasten, wobei der Bildsensor angeordnet ist, um die Schaltmittel zu Steuern, um den zweiten Knoten mit dem Photosensor während einer ersten Integrationsphase zu verbinden; um die Schaltmittel zu Steuern, um den zweiten Knoten von dem Photosensor während einer zweiten Integrationsphase zu trennen; und um die Lesemittel zu Steuern, so dass diese unabhängig den ersten und den zweiten Spannungswert am Ende der zweiten Integrationsphase lesen.

2. Der Bildsensor nach Anspruch 1, wobei die Lesemittel einen ersten Leseschaltkreis (503, 520) aufweisen, der betrieben werden kann, um den ersten Spannungswert zu lesen und einen zweiten Leseschaltkreis (506, 514) aufweisen, der betrieben werden kann, um den zweiten Spannungswert zu lesen.

3. Der Bildsensor nach Anspruch 1 oder 2, weist ferner einen ersten Transistor (506) auf, der gesteuert werden kann, um selektiv den zweiten Knoten mit dem Photosensor zu verbinden.

4. Der Bildsensor nach einem der vorhergehenden Ansprüche, wobei der Bildsensor ferner einen dritten Knoten (609) mit einer dritten Kapazität aufweist und der selektiv mit dem Photosensor verbunden werden kann, wobei der Bildsensor ferner angeordnet ist, um die Schaltmittel zu Steuern, um:
den dritten Knoten mit dem Photosensor während der ersten und der zweiten Integrationsphase zu verbinden; und
den zweiten und dritten Knoten von dem Photosensor während einer dritten Integrationsphase zu trennen.

5. Der Bildsensor nach einem der vorhergehenden Ansprüche, wobei der Bildsensor ferner Rücksetzmittel (505) aufweist, zum Zurücksetzen des ersten und zweiten Spannungswertes an dem ersten und zweiten Knoten.

6. Ein Verfahren zum Abtasten einen Bildes unter Verwendung eines Bildsensors der eine Vielzahl von Pixel aufweist, wobei jedes der Pixel einen Photosensor (502) aufweist, einen ersten Knoten (507) mit einer ersten Kapazität, wobei der Knoten mit dem Photosensor verbunden ist, einen zweiten Knoten (509) mit einer zweiten Kapazität und Schaltmittel (506) zum selektiven Verbinden des zweiten Knotens mit dem Photosensor, wobei das Verfahren einen variablen Empfindlichkeitsmodus aufweist, der durch die Folgenden Schritte **gekennzeichnet** ist:
Steuern der Schaltmittel, um den zweiten Knoten mit dem Photosensor während einer ersten Integrationsphase zu verbinden;
Speichern eines zweiten Spannungswertes an dem zweiten Knoten;
Steuern der Schaltmittel, um den zweiten Knoten von dem Photosensor während einer zweiten Integrationsphase zu trennen;
Speichern eines ersten Spannungswertes an dem ersten Knoten; und
unabhängiges Lesen des ersten und des zweiten Spannungswertes am Ende der zweiten Integrationsphase.

7. Das Verfahren nach Anspruch 6, wobei die Pixel des Bildsensors in Reihen angeordnet sind und die Schritte des Betreibens des variablen Empfindlichkeitsmodus an den Pixel jeder Reihe nacheinander ausgeführt werden.

8. Das Verfahren nach Anspruch 6 oder 7, wobei das Verfahren ferner einen Verschlussbetriebsmodus aufweist, der die folgenden Schritte aufweist: Speichern eines dritten Spannungswertes an dem zweiten Knoten für jedes Pixel in dem Bildsensor, Steuern der Schaltmittel, um den zweiten Knoten von dem Photosensor zu isolieren, und Lesen des dritten Spannungswertes.

9. Das Verfahren nach Anspruch 8, wobei der Verschlussmodus Schritt des Steuerns der Schaltmittel, um den zweiten Knoten zu isolieren, zur gleichen Zeit in allen Pixel des Bildsensors ausgeführt wird.

10. Das Verfahren nach einem der Ansprüche 6 bis 9, wobei das Verfahren ferner Folgendes aufweist:
einen Hochempfindlichkeitsbetriebsmodus, der die Schritte des Steuerns der Schaltmittel, um den zweiten Knoten von dem Photosensor während des Hochempfindlichkeitsmodus zu trennen, des Speicherns eines vierten Spannungswertes an dem ersten Knoten und des Lesens des vierten Spannungswertes.

11. Das Verfahren nach einem der Ansprüche 6 bis 10, wobei das Verfahren ferner Folgendes aufweist:
einen Hochkapazitätsbetriebsmodus der das Steuern der Schaltmittel aufweist, um den zweiten Knoten mit dem Photosensor während des Hochkapazitätsmodus zu verbinden, das Speichern eines fünften Spannungswertes an dem ersten und zweiten Knoten, und das Lesen des fünften Spannungswertes an dem ersten und zweiten Knoten.

12. Das Verfahren nach Anspruch 6, wobei der Bildsensor ferner einen dritten Knoten (609) mit einer dritten Kapazität aufweist und der selektiv mit dem Photosensor verbunden werden kann, wobei das Verfahren einen Lesewährend-des-Integrierens-Modus aufweist, der das Alternieren zwischen einer ersten und zweiten Betriebsphase aufweist, wobei die erste Phase das Lesen eines ersten Spannungswertes, der an dem zweiten Knoten gespeichert ist, während ein zweiter Spannungswert an dem dritten Knoten gespeichert wird, aufweist, und wobei die zweite Phase das Lesen eines zweiten Spannungswertes, der an dem dritten Knoten gespeichert ist während ein erster Spannungswert an dem zweiten Knoten gespeichert wird, aufweist.

13. Das Verfahren nach Anspruch 12, wobei die erste Phase ferner, vor dem Lesen des ersten Spannungswertes, der an dem zweiten Knoten gespeichert ist, das Steuern eines ersten Schaltmittels aufweist, um den zweiten Knoten von dem Photosensor zu trennen, und das Steuern eines zweiten Schaltmittels, um den dritten Knoten mit dem Photosensor zu verbinden, und wobei die zweite Phase ferner, vor dem Lesen des Spannungswertes, der an dem dritten Knoten gespeichert ist, das Steuern des zweiten Schaltmittels aufweist, um den dritten Knoten von dem Photosensor zu trennen, und das Steuern des ersten Schaltmittels, um den zweiten Knoten mit dem Photosensor zu verbinden.

## Revendications

1. Capteur d'image comprenant une pluralité de pixels, chacun comprenant:
un capteur photosensible (502) ;
un premier noeud (507) ayant une première capacité et connecté au capteur photosensible ;
un deuxième noeud (509) ayant une deuxième capacité et connecté sélectivement au capteur photosensible ;
des moyens de lecture (503, 520, 516, 514) actionnables pour lire indépendamment une première valeur de tension mémorisée au niveau du premier noeud, et une deuxième valeur de tension mémorisée au niveau du deuxième noeud ;
des moyens de commutation (506) pour connecter sélectivement le deuxième noeud au capteur photosensible ; et **caractérisé en ce que**, pour détecter une image, le capteur d'image est agencé pour contrôler les moyens de commutation pour connecter, pendant une première phase d'intégration, le deuxième noeud au capteur photosensible ; pour contrôler les moyens de commutation pour déconnecter, pendant une deuxième phase d'intégration, le deuxième noeud du capteur photosensible ; et pour contrôler les moyens de lecture pour lire indépendamment les première et deuxième valeurs de tension à la fin de la deuxième phase d'intégration.

2. Capteur d'image selon la revendication 1, dans lequel les moyens de lecture comprennent un premier circuit de lecture (503, 520) actionnable pour lire la première valeur de tension et un deuxième circuit de lecture (506, 514) actionnable pour lire la deuxième valeur de tension.

3. Capteur d'image selon les revendications 1 ou 2, comprenant en outre un premier transistor (506) contrôlable pour connecter sélectivement le deuxième noeud au capteur photosensible.

4. Capteur d'image selon l'une quelconque des revendications précédentes, comprenant en outre un troisième noeud (609) ayant une troisième capacité et connecté sélectivement au capteur photosensible, le capteur d'image étant en outre agencé pour contrôler les moyens de commutation pour :
connecter, pendant les première et deuxième phases d'intégration, le troisième noeud au capteur photosensible ; et
déconnecter, pendant une troisième phase d'intégration, les deuxième et troisième noeuds du capteur photosensible.

5. Capteur d'image selon l'une quelconque des revendications précédentes, comprenant en outre des moyens de réinitialisation (505) pour réinitialiser les première et deuxième valeurs de tension au niveau des premier et deuxième noeuds.

6. Procédé pour détecter une image en utilisant un capteur d'image comprenant une pluralité de pixels comprenant chacun un capteur photosensible (502), un premier noeud (507) ayant une première capacité et connecté au capteur photosensible, un deuxième noeud (509) ayant une deuxième capacité, et des moyens de commutation (506) pour connecter sélectivement le deuxième noeud au capteur photosensible, le procédé comprenant un mode à sensibilité variable comprenant les étapes caractéristiques suivantes :
contrôler les moyens de commutation pour connecter, pendant une première phase d'intégration, le deuxième noeud au capteur photosensible ;
mémoriser une deuxième valeur de tension au niveau du deuxième noeud ;
contrôler les moyens de commutation pour déconnecter, pendant une deuxième phase d'intégration, le deuxième noeud du capteur photosensible ;
mémoriser une première valeur de tension au niveau du premier noeud ; et
lire indépendamment les première et deuxième valeurs de tension à la fin de la deuxième phase d'intégration.

7. Procédé selon la revendication 6, dans lequel les pixels du capteur d'image sont agencés en rangées et les étapes du mode de fonctionnement à sensibilité variable sont réalisées sur les pixels de chaque rangée séquentiellement.

8. Procédé selon la revendication 6 ou 7, comprenant en outre un mode de fonctionnement d'obturateur comprenant les étapes consistant à, pour chaque pixel dans le capteur d'image, mémoriser une troisième valeur de tension au niveau du deuxième noeud, contrôler les moyens de commutation pour isoler le deuxième noeud du capteur photosensible, et lire la troisième valeur de tension.

9. Procédé selon la revendication 8, dans lequel l'étape de mode d'obturateur consistant à contrôler les moyens de commutation pour isoler le deuxième noeud est réalisée en même temps dans tous les pixels du capteur d'image.

10. Procédé selon l'une quelconque des revendications 6 à 9, comprenant en outre :
un mode de fonctionnement à haute sensibilité comprenant les étapes consistant à contrôler, pendant le mode à haute sensibilité, les moyens de commutation pour déconnecter le deuxième noeud du capteur photosensible, mémoriser une quatrième valeur de tension au niveau du premier noeud, et lire la quatrième valeur de tension.

11. Procédé selon les revendications 6 à 10, comprenant en outre :
un mode de fonctionnement à haute capacité comprenant le fait de contrôler, pendant le mode à haute capacité, les moyens de commutation pour connecter le deuxième noeud au capteur photosensible, mémoriser une cinquième valeur de tension au niveau des premier et deuxième noeuds, et lire la cinquième valeur de tension à partir des premier et deuxième noeuds.

12. Procédé selon la revendication 6, dans lequel le capteur d'image comprend en outre un troisième noeud (609) ayant une troisième capacité et connecté sélectivement au capteur photosensible, le procédé comprenant un mode de lecture pendant l'intégration, comprenant le fait d'alterner entre des première et deuxième phases de fonctionnement, la première phase comprenant la lecture d'une première valeur de tension mémorisée au niveau du deuxième noeud pendant la mémorisation d'une deuxième valeur de tension au niveau du troisième noeud, la deuxième phase comprenant la lecture d'une deuxième valeur de tension mémorisée au niveau du troisième noeud pendant la mémorisation d'une première valeur de tension au niveau du deuxième noeud.

13. Procédé selon la revendication 12, dans lequel la première phase comprend, avant la lecture de la première valeur de tension mémorisée au niveau du deuxième noeud, le contrôle de premiers moyens de commutation pour déconnecter le deuxième noeud du capteur photosensible, et le contrôle de deuxièmes moyens de commutation pour connecter le troisième noeud au capteur photosensible, et dans lequel la deuxième phase comprend, avant la lecture de la valeur de tension mémorisée au niveau du troisième noeud, le contrôle des deuxièmes moyens de commutation pour déconnecter le troisième noeud du capteur photosensible, et le contrôle des premiers moyens de commutation pour connecter le deuxième noeud au capteur photosensible.
